# EUROPEAN PATENT APPLICATION

(11) **EP 3 442 035 A1**
(43) Date of publication of application: **13.02.2019**
(21) Application number: 18187300.1
(22) Date of filing: 03.08.2018
(51) Int. Cl.: H01L 31/048, H01L 31/049, B32B 37/20

(54) **PACKAGING METHOD FOR PHOTOVOLTAIC MODULE**

(30) Priority: 11.08.2017 CN 201710685904
(71) Applicant: Beijing Apollo Ding Rong Solar Technology Co., Ltd., Beijing 100176 (CN)
(72) Inventor: HUO, Yanyin, Beijing, 100176 (CN); CAO, Zhifeng, Beijing, 100176 (CN)
(74) Representative: Peguet, Wilfried

(57) **Abstract**

Provided is a packaging method for a photovoltaic module. The method comprises: providing a flexible substrate roll (1) and unwinding the roll (1) at an unwinding speed to obtain an extended flexible substrate (2), the substrate including a conductive film (21), a first packaging adhesive film (22) and a polymer substrate (23) which are stacked from top to bottom; providing a chip (211) and a diode and connecting the chip (211) and the diode to the conductive film; and providing a second packaging adhesive film (24), a first and second intermediate films (26), a water resistant film (27) and a back-sheet (28), and packaging the these films and the back-sheet respectively on the substrate to form the photovoltaic module while the substrate transporting successively through a first to fourth working stations (51-54) at a preset speed, and reeling to form a photovoltaic module roll (40) for performing temperature-pressure control processing.

## Description

### Cross-reference to Related Applications

This application claims priority to Chinese patent application No. 201710685904.6 filed to State Intellectual Property Office of China on August 11, 2017, all of which are hereby incorporated by reference in their entireties.

### Technical Field

The present disclosure relates to the method of manufacturing solar cells, and in particular to a packaging method for a photovoltaic module.

### Background

Solar photovoltaic modules may be classified into two categories: crystalline silicon photovoltaic modules and flexible photovoltaic modules. The crystalline silicon photovoltaic modules are difficult to produce continuously in a roll-to-roll process due to the existence of glass in the crystalline silicon photovoltaic modules. While, the flexible photovoltaic modules, e.g., CIGS (CuInxGa(1-x)Se2) cells with a substrate made of stainless steel or organic materials, may be produced continuously in the roll-to-roll manner, which significantly enhances the production efficiency.

In the existing packaging process of flexible photovoltaic modules (e.g., CIGS cells), packaging equipment such as laminating machine is used for heating and lamination. Nevertheless, in the existing packaging process, the flexible photovoltaic is cut into a predetermined size and then conducted by heat and pressure treatment process, which makes it impossible to achieve continuous production, thereby affecting the production efficiency.

### Summary of the Disclosure

To overcome at least part of the technical problems in the prior art, the present disclosure provides a packaging method for a photovoltaic module to achieve uninterruptible and continuous production, thereby improving the production efficiency.

According to an aspect of the present disclosure, a packaging method for a photovoltaic module is provided, which comprises:
an unwinding step, including providing a flexible substrate roll (1) and unwinding the flexible substrate roll (1) at a set unwinding speed to obtain an expanded flexible substrate, wherein the flexible substrate comprises a conductive film, a first packaging adhesive film and a polymer substrate which are stacked from top to bottom;
a connecting step, including: providing chips and diodes, and connecting the chip and the diode to the conductive film of the flexible substrate;
a packaging step, including: providing a second packaging adhesive film, a first intermediate film, a second intermediate film, a water resistant film and a back-sheet, and packaging the second packaging adhesive film, the first intermediate film, the second intermediate film, the water resistant film and the back-sheet respectively on the flexible substrate to form the photovoltaic module when transporting the flexible substrate to successively pass through a first working station, a second working station, a third working station and a fourth working station at a preset speed, and then rewinding the photovoltaic module to form a photovoltaic module roll; and
a temperature and pressure control step, including performing temperature and pressure control processing on the photovoltaic module roll.

The conductive film is a conductive copper film. The first packaging adhesive film and the second packaging adhesive film are thermoplastic olefin (TPO) adhesive films. The material for the polymer substrate is polyethylene terephthalate (PET) or polyethylene naphthalate (PEN) or polyimide (PI) or a combination thereof. The first intermediate film and the second intermediate film are polyvinyl butyral (PVB) adhesive films.

The packaging step may include:
adhering a top surface of the flexible substrate to the second packing adhesive film, when transporting the flexible substrate to pass through the first working station;
adhering two relative surfaces of the flexible substrate to the first intermediate film and the second intermediate film respectively and synchronously, when transporting the flexible substrate to pass through the second working station at a first preset speed;
adhering a upper surface of the first intermediate film of the flexible substrate to the water resistant film, when transporting the flexible substrate to pass through the third working station at a second preset speed; and
adhering a bottom surface of the flexible substrate to the back-sheet to obtain the photovoltaic module, when transporting the flexible substrate to pass through the fourth working station at a third preset speed.

The first preset speed, the second preset speed and the third preset speed may be between 0.2 m/min and 5 m/min.

The back-sheet may be a single-sided fluorine-containing back-sheet or a double-sided fluorine-containing back-sheet. The packaging method may further comprise:
transporting the photovoltaic module to a preheating chamber of a roll laminating machine at a fourth preset speed for performing three preheating phases, wherein the three preheating phases include:
a first preheating phase of preheating in a temperature range of 50 °C to 70 °C;
a second preheating phase of preheating in a temperature range of 90 °C to 110°C; and
a third preheating phase of preheating in a temperature range of 130 °C to 150°C.

The fourth preset speed may be between 0.5 m/min and 3 m/min.

The packaging method may further comprise heating and pressurizing the photovoltaic module after the photovoltaic module is transported to the preheating chamber of the roll laminating machine at the fourth preset speed.

The packaging method may further comprise cooling the photovoltaic module after the photovoltaic module is heated and pressurized, and rewinding the photovoltaic module to form the photovoltaic module roll when the temperature of the photovoltaic module is equal to or less than 40 °C.

In the packaging method, a separating plate may be placed between adjacent sheets of the photovoltaic module roll while rewinding the photovoltaic module.

In the packaging method, the separating plate may be a silicone plate.

In the packaging method, the temperature and pressure control step may include: transporting the photovoltaic module roll to a pressure forming equipment to adjust temperature and pressure in the pressure forming equipment, so as to laminate the photovoltaic module roll.

In the packaging method, the step of adjusting temperature and pressure in the pressure forming equipment may include:
increasing temperature and pressure for the photovoltaic module roll in a first preset time period and a first preset temperature range;
maintaining the temperature and the pressure for the photovoltaic module roll in a second preset time period;
decreasing the temperature and maintaining the pressure for the photovoltaic module roll in a third preset time period; and
decreasing the temperature and the pressure for the photovoltaic module roll.

In the packaging method, an upper limit of the pressure is kept to 10 bar to 12 bar in the phase of increasing the temperature and the pressure, the lower limit of the temperature is kept to 50 °C in the phase of decreasing the temperature and maintaining the pressure, and the pressure is decreased to a standard atmospheric pressure and the temperature for the photovoltaic module roll is decreased to room temperature in the phase of decreasing the temperature and the pressure.

In the packaging method, the first preset time period is between 30 minutes and 50 minutes, the first preset temperature is between 130 °C and 140 °C, the second preset time period is between 50 minutes and 70 minutes, and the third preset time period is between 120 minutes and 150 minutes.

The packaging method may further include releasing the pressure of the pressure forming equipment and taking the photovoltaic module roll out of the pressure forming equipment after performing the temperature and pressure control processing on the photovoltaic module roll.

The pressure forming equipment may be an autoclave.

According to the packaging method for a photovoltaic module provided by the present disclosure, the flexible substrate passes through respective working stations of the laminating machine at preset speeds, and the films such as the second packaging adhesive film, the first intermediate film, the second intermediate film, the water resistant film are packaged on the flexible substrate passing through the working stations, so as to form the photovoltaic module. Compared with the existing packaging method, in the packaging method in embodiments of the present disclosure, the cutting process is removed to save time; and the efficiency of uninterrupted and continuous roll-to-roll production from cells to modules is improved. Furthermore, products manufactured by the packaging method for a photovoltaic module provided by the present disclosure have a high transmittance and strong cohesiveness between films. This improves the water resistance and aging resistance of the laminated material of the photovoltaic module. Thus the photovoltaic module works more stably and has a longer service life.

### Brief Description of the Drawings

Fig. 1 is a flowchart of a packaging method for a photovoltaic module according to an embodiment of the present disclosure;
Fig. 2 is a flowchart of a packaging method for a photovoltaic module according to an embodiment of the present disclosure;
Fig. 3 is a flowchart of a packaging method for a photovoltaic module according to an embodiment of the present disclosure;
Fig. 4 is a flowchart of a packaging method for a photovoltaic module according to an embodiment of the present disclosure; and
Fig. 5 is a process flow diagram of a packaging method for a photovoltaic module according to an embodiment of the present disclosure.

### Detailed Description of the Embodiments

Below is detailed description of embodiments of the present disclosure in conjunction with the drawings. In the drawings, same or similar reference signs identify same or similar elements or elements having same or similar functions. It should be noted that the embodiments described below in conjunction with the drawings are illustrative, i.e., the embodiments are intended to illustrate the present disclosure, but not to limit the present disclosure.

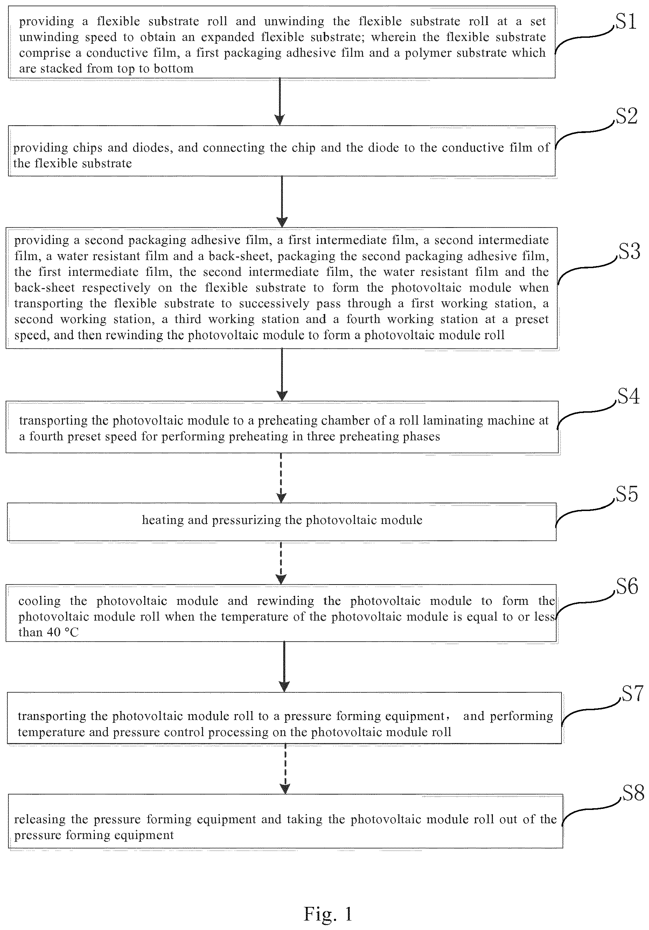

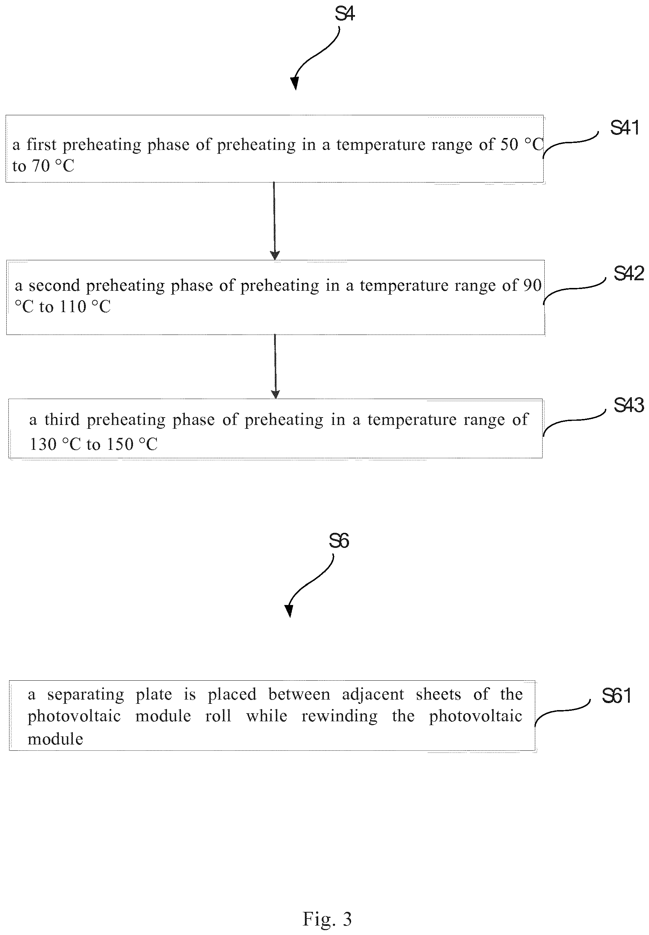

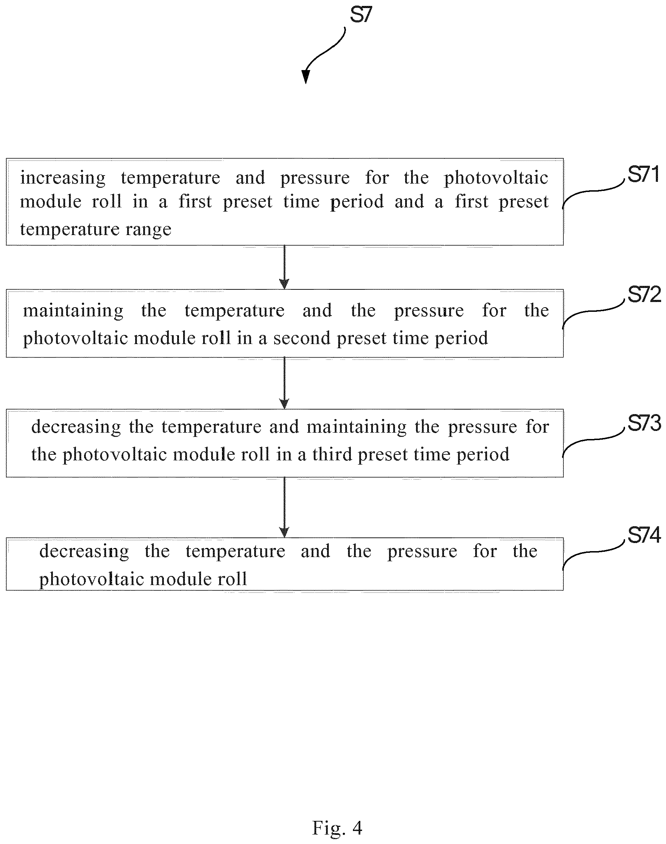

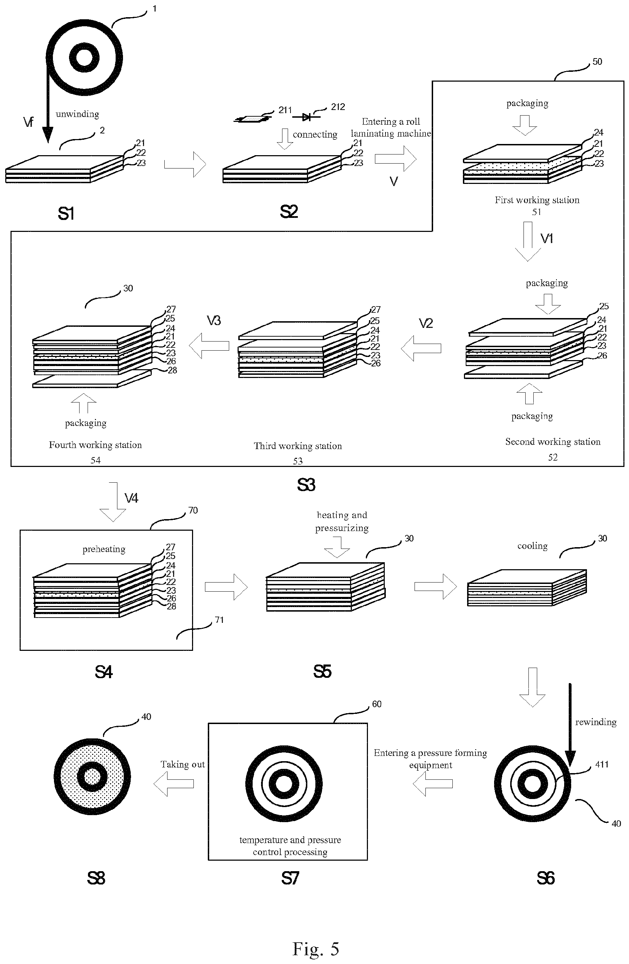

Figs. 1 to 4 illustrate flowcharts of a packaging method for a photovoltaic module according to an embodiment of the present disclosure. Fig. 5 illustrates a process flow diagram showing a packaging method for a photovoltaic module according to an embodiment of the present disclosure. The packaging method for a photovoltaic module of the embodiments of the present disclosure is described below by taking the packaging of a flexible photovoltaic module as an example in conjunction of Figs. 1 to 5. As shown in Figs. 1 to 5, the packaging method for a photovoltaic module according to the embodiments of the present disclosure includes the steps described below.

In step S1, i.e., unwinding step, a flexible substrate roll 1 is provided, and the flexible substrate roll 1 is unwound at a set unwinding speed Vf to obtain an expanded flexible substrate 2, wherein the flexible substrate 2 includes a conductive film 21, a first packaging adhesive film 22 and a polymer substrate 23 which are stacked from top to bottom and are patterned. In this step, the flexible substrate 2, which is stored in a roll form, is stored in an environment having a humidity less than 5% RH, and the flexible substrate 2 has a thickness of about 0.3 mm to 0.5 mm.

In step S2, i.e., connecting step, chips 211 and diodes 212 are provided, and the chip 211 and the diode 212 are connected to the conductive film 21 of the flexible substrate 2.

In step S3, i.e., packaging step, a second packaging adhesive film 24, a first intermediate film 25, a second intermediate film 26, a water resistant film 27 and a back-sheet 28 are provided; the second packaging adhesive film 24, the first intermediate film 25, the second intermediate film 26, the water resistant film 27 and the back-sheet 28 are respectively packaged on the flexible substrate 2 when the flexible substrate 2 is transported to successively pass through a first working station 51, a second working station 52, a third working station 53 and a fourth working station 54 of a laminating machine 50 at a preset speed V to form a photovoltaic module 30; and the photovoltaic module 30 is rewound to form a photovoltaic module roll 40; and

In step S7, i.e., temperature and pressure control step, temperature and pressure control processing is performed on the photovoltaic module roll 40.

In an exemplary embodiment, for example, the conductive film 21 may be a conductive copper film; the first packaging adhesive film 22 and the second packaging adhesive film 24 each may be thermoplastic olefin (TPO) adhesive films; the material for the polymer substrate 23 may be polyethylene terephthalate (PET) or polyethylene naphthalate (PEN) or polyimide (PI) or a combination thereof; and the first intermediate film 25 and the second intermediate film 26 may be polyvinyl butyral (PVB) adhesive films.

According to the packaging method for a photovoltaic module in the embodiments of the present disclosure, the flexible substrate passes through respective working stations of the laminating machine at preset speeds, the films such as the second packaging adhesive film, the first intermediate film, the second intermediate film, the water resistant film are packaged on the flexible substrate passing through the working stations to form the photovoltaic module, and the photovoltaic module is rewound to form a photovoltaic module roll. Compared with the existing packaging method (in the packaging process the photovoltaic module is cut to a preset size), in the packaging method in embodiments of the present disclosure, the cutting process is removed to save time; the efficiency of uninterrupted and continuous roll-to-roll production from cells to modules is improved.

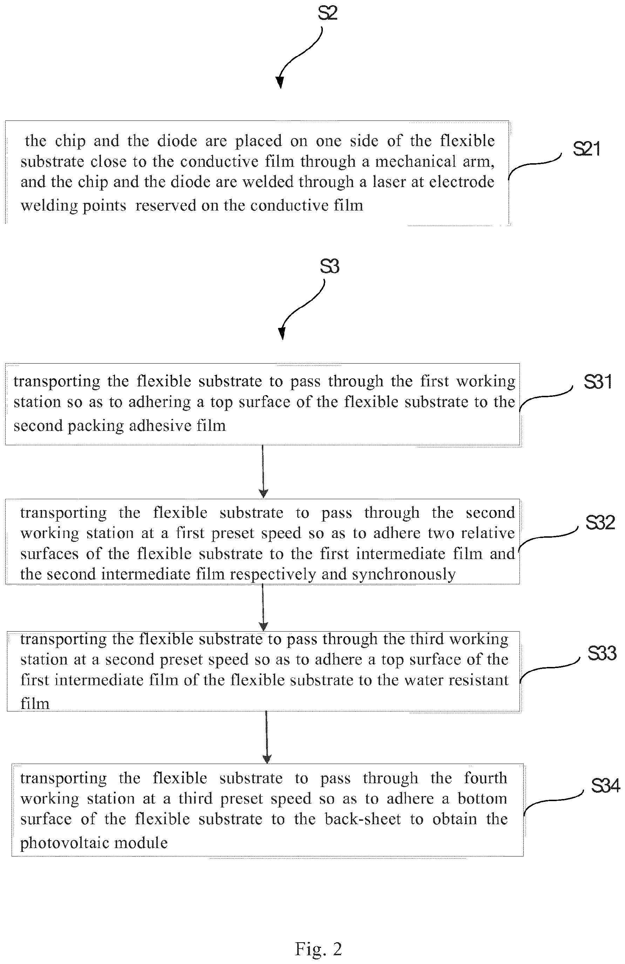

As shown in Figs. 2 and 5, in an exemplary embodiment, the step S2 may include the steps described below.

In step S21, the chip 211 and the diode 212 are connected to the conductive film 21. Specifically, in the step S21, the chip 211 and the diode 212 are placed on one side of the flexible substrate 11 close to the conductive film 21 through a mechanical arm, and the chip 211 and the diode 212 are welded through a laser at electrode welding points (not shown) reserved on the conductive film 21, so as to achieve the connection of chips 211 in series or in parallel and the bypass connection of the diode 212. In other words, the chip 211 and the diode 212 are connected to the conductive film 21.

As shown in Figs. 2 and 5, in an exemplary embodiment, the step S3 may include the steps described below.

In step S31, the flexible substrate, on which the chip has been placed and the diode has been connected, passes through a first working station 51 of a laminating machine 50. At the first working station 51, the top surface of the flexible substrate 2 is adhered to the second packaging adhesive film 24. In an exemplary embodiment, a roll laminating machine may heat and pressurize the flexible substrate 2 obtained from the step S31. Then, the flexible substrate 2 is directly transported to the next process; or the flexible substrate 2 is cooled by air, and when the temperature of the flexible substrate decreases to below about 40 °C, a rewinding machine (not shown) may reel the flexible substrate 2 to form a roll with a diameter about 800 mm. The roll is temporarily placed in an environment having the humidity less than 5% RH.

In step S32, the flexible substrate 2 obtained from the step S31 is transported to pass through a second working station 52 of the laminating machine 50 at a first preset speed V1. At the second working station 52, two relative surfaces (i.e., the top surface and the bottom surface which faces to the top surface) of the flexible substrate 2 are synchronously adhered to the first intermediate film 25 and the second intermediate film 26 respectively.

In step S33, the flexible substrate 2 obtained from the step S32 is transported to pass through a third working station 53 of the laminating machine 50 at a second preset speed V2. At the third working station 53, the top surface of the first intermediate film 25 on the flexible substrate 2 is adhered to the water resistant film 27 (e.g., a weather resistant and water resistant film); and

In step S34, the flexible substrate 2 obtained from the step S33 is transported to pass through a fourth working station 54 of the laminating machine 50 at a third preset speed V3. At the fourth working station 54, the bottom surface of the flexible substrate 2 is adhered to the back-sheet 28, so as to obtain the photovoltaic module 30. In an exemplary embodiment, for example, the back-sheet 28 may be a single-sided or double-sided fluorine-containing back-sheet that has properties such as long-term aging (humid, dry, heat and ultraviolet) resistance, electrical insulation, vapor barrier.

It can be understood by those skilled in the art that the first preset speed V1, the second preset speed V2 and the third preset speed V3 may be the same, i.e., the flexible substrate 2 may be transported at a constant speed, so as to be laminated. The flexible substrate 2 may also be transported at a variable speed. The preset speeds described above are set according to the technical requirements of the photovoltaic module roll to be formed.

In this embodiment, the first preset speed V1, the second preset speed V2 and the third preset speed V3 may be the same and have a range from 0.2 m/min to 5 m/min, such that the lamination effect is fully achieved.

As shown in Figs. 1, 3 and 5, in an exemplary embodiment, the packaging method described above may further include the steps described below.

In step S4, the photovoltaic module 30 is transported to a preheating chamber 71 of the roll laminating machine 70 for preheating at a fourth preset speed V4 (i.e., a fourth preheating speed). The fourth preheating speed V4 is about 0.5 m/min to 3 m/min. In an exemplary embodiment, the fourth preheating speed V4 is about 1 m/min to 2 m/min. At this preheating speed, the photovoltaic module may be fully preheated, which further improves the thermal performance of the photovoltaic module.

The roll laminating machine 70 performs heating by means of, for example, resistance heating (e.g., resistance wire heating) or infrared heating (e.g., infrared tube heating), and the roll laminating machine 70 exerts pressure on the photovoltaic module 30 through the relative rolling motion of upper and lower high-temperature resistance rubber roller (not shown). In an exemplary embodiment, the preheating chamber 71 of the roll laminating machine 70 has three phases, i.e., a first preheating phase, a second preheating phase and a third preheating phase. The temperature of the three phases increases successively. Specifically, the chamber with the first preheating phase has a length of about 1 m to 2 m and has a temperature range of about 50 °C to 70 °C; the chamber with the second preheating phase has a length of about 1 m to 2 m and has a temperature range of about 90 °C to 110 °C; the chamber with the third preheating phase has a length of about 1 m to 2 m and has a temperature range of about 130 °C to 150 °C. In other words, the step S4, in which the photovoltaic module 30 is transported to the preheating chamber 71 of the roll laminating machine 70 at the fourth preset speed V4 for preheating, may successively include the three preheating phases described below.

In step S41, the first preheating phase for preheating is performed in a temperature range of 50°C to 70 °C.

In step S42, the second preheating phase for preheating is performed in a temperature range of 90 °C to 110 °C.

In step S43, a third preheating phase for preheating is performed in a temperature range of 130 °C to 150 °C.

As shown in Figs. 1 and 5, in an exemplary embodiment, the packaging method described above may further include the steps described below.

In step S5, the photovoltaic module 30 is heated and pressurized. This phase is divided into two phases, i.e., a first phase and a second phase. The first phase has a temperature range of about 130 °C to 150 °C. The distance between the upper rubber roller and the lower rubber roller is about 0.5 mm to 1mm less than the total thickness of the composite materials. The rubber rollers have a diameter of about 1 m to 1.6 m and have a length of about 2 m to 3 m. The second phase has a temperature range of about 130 °C to 150 °C. The distance between the upper rubber roller and the lower rubber roller is about 1 mm to 2mm less than the total thickness of the composite materials. The rubber rollers have a diameter of about 1 m to 1.6 m and have a length of about 2 m to 3 m.

As shown in Figs. 1, 3 and 5, in an exemplary embodiment, the packaging method described above may further include the step described below.

In step S6, the photovoltaic module 30 is cooled (e.g., air cooling); when the temperature decreases to below about 40 °C, the photovoltaic module 30 is rewound to obtain the photovoltaic module roll 40. The roll has a diameter which is equal to or greater than 1000 mm. In an exemplary embodiment, the packaging method described above may further include step S61, in which when the photovoltaic module 30 is rewound, a separating plate 411 (e.g., a silicone plate) may be placed between adjacent sheets of the roll manually or mechanically. The separating plate 411 has a thickness of about 8 mm to 10 mm, a length slightly less than the width of the photovoltaic module and a width of about 10 mm.

As shown in Figs. 1, 4 and 5, in an exemplary embodiment, the step S7 described above may include that the entire photovoltaic module roll 40 is transported into a pressure forming equipment 60 for performing temperature and pressure control processing on the photovoltaic module roll 40. In an exemplary embodiment, the temperature and pressure control processing, for example, includes that the temperature and pressure in the pressure forming equipment 60 is adjusted to laminate the photovoltaic module roll 40. The pressure forming equipment 60 is for example an autoclave.

According to the packaging method for a photovoltaic module in the embodiments of the present disclosure, the entire photovoltaic module roll 40 is transported into the pressure forming equipment 60, the temperature and pressure control processing is performed on the photovoltaic module roll 40 in the pressure forming equipment 60. Therefore, the performance of the photovoltaic module 30 is improved.

In an exemplary embodiment, in the step S7 described above, the adjustment of the temperature and pressure in the pressure forming equipment 60 includes four phases: increasing temperature and pressure, maintaining temperature and pressure, maintaining pressure and decreasing temperature, and decreasing pressure and temperature. Specifically, in the four phases, the steps described below are performed.

In step S71, i.e., the phase of increasing temperature and pressure, the temperature and pressure for the photovoltaic module roll 40 is increased (i.e., the temperature and pressure in the pressure forming equipment is increased) in a first preset time period and a first preset temperature range while maintaining the upper limit of the pressure at about 10 bar to 12 bar. The first preset time period may be about 30 minutes to 50 minutes. The first preset temperature range may be about 130 °C to 140 °C.

In step S72, i.e., the phase of maintaining temperature and pressure, the temperature and pressure for the photovoltaic module roll 40 is maintained (i.e., the temperature and pressure in the pressure forming equipment 60 is maintained) in a second preset time period. The second preset time period may be about 50 minutes to 70 minutes.

In step S73, i.e., the phase of maintaining pressure and decreasing temperature, the temperature is decreased and the pressure is maintained for the photovoltaic module roll 40 (i.e., the pressure in the pressure forming equipment 60 is maintained and the temperature in the pressure forming equipment is decreased) in a third preset time period while controlling the lower limit of the temperature to 50 °C. The third preset time period may be about 120 minutes to 150 minutes.

In step S74, i.e., the phase of decreasing pressure and temperature, the pressure and temperature for the photovoltaic module roll 40 is decreased (i.e., the pressure and temperature in the pressure forming equipment 60 is decreased). In the phase of decreasing pressure and temperature, the pressure is decreased to a standard atmospheric pressure and the temperature to room temperature.

The phases of increasing temperature and pressure, maintaining temperature and pressure, maintaining pressure and decreasing temperature, and decreasing pressure and temperature are performed for the photovoltaic module roll 40 in the pressure forming equipment 60. In this way, the obtained photovoltaic module 30 has better light transmission, and the transmittance higher than the photovoltaic module obtained from ordinary lamination process. Furthermore, the cohesiveness of the respective films is improved, thereby achieving stronger cohesiveness. This improves the water resistance and aging resistance of the laminated materials. Thus the photovoltaic module works more stably and has longer service life.

When the temperature and pressure control processing is performed on the photovoltaic module roll 40 transported into the pressure forming equipment 60, the above separating plate 411 can effectively separate the adjacent sheets of the roll, so as to heat the sheets uniformly.

As shown in Figs. 1 and 5, in an exemplary embodiment, the packaging method described above may further include step S8, in which after the pressure forming equipment 60 is released, the pressure forming equipment 60 is opened to push out the photovoltaic module roll 40. When the separating plate 411 in the photovoltaic module roll 40 is removed, the photovoltaic module roll 40 is unwound mechanically, and the unwound photovoltaic module 30 is then cleaned. A junction box (not shown) is installed at a lead wire reserved in the photovoltaic module 30. The photovoltaic module, on which the junction box is installed, undergoes a power test, is checked and packed.

As stated above, according to the packaging method for a photovoltaic module in the embodiments of the present disclosure, the flexible substrate passes through respective working stations of the laminating machine at preset speeds, and the films such as the second packaging adhesive film, the first intermediate film, the second intermediate film, the water resistant film are packaged on the flexible substrate passing through the working stations, so as to form the photovoltaic module. Compared with the existing packaging method, in the packaging method in embodiments of the present disclosure, the cutting process is removed to save time; the efficiency of uninterrupted and continuous roll-to-roll production from cells to modules is improved. Moreover, the power consumption is reduced, the degree of automation is improved, and the quality can be controlled easily.

Furthermore, according to the packaging method for a photovoltaic module in the embodiments of the present disclosure, the temperature and pressure control processing is performed on the photovoltaic module through the pressure forming equipment, making the photovoltaic module better light transmittance. Furthermore, compared with ordinary lamination process, the obtained products have high transmittance and cohesiveness between films. This improves the water resistance and aging resistance of the laminated materials of the photovoltaic module. Thus the photovoltaic module works more stably and has a longer service life.

The foregoing description of the exemplary embodiments of the present disclosure has been provided for the purposes of illustration and description. It is not intended to be exhaustive or to limit the disclosure to the precise forms disclosed. Obviously, modifications and variations may be realized by those skilled in the art. The described embodiments were chosen and described in order to best explain the principles of the technology and its practical application to thereby enable others skilled in the art to understand the present disclosure for implementing various embodiments and various modifications as are suited to the particular use contemplated. It is intended that the scope of the present disclosure be defined by the appended claims and their equivalent contents.

## Claims

1. A packaging method for a photovoltaic module, comprising:
an unwinding step, including: providing a flexible substrate roll (1) and unwinding the flexible substrate roll (1) at a set unwinding speed (Vf) to obtain an expanded flexible substrate (2); wherein the flexible substrate (2) comprise a conductive film (21), a first packaging adhesive film (22) and a polymer substrate (23) which are stacked from top to bottom;
a connecting step, including: providing chips (211) and diodes (212), and connecting the chip (211) and the diode (212) to the conductive film (21) of the flexible substrate (2);
a packaging step, including: providing a second packaging adhesive film (24), a first intermediate film (25), a second intermediate film (26), a water resistant film (27) and a back-sheet (28), packaging the second packaging adhesive film (24), the first intermediate film (25), the second intermediate film (26), the water resistant film (27) and the back-sheet (28) respectively on the flexible substrate (2) to form the photovoltaic module (30) when transporting the flexible substrate (2) to successively pass through a first working station (51), a second working station (52), a third working station (53) and a fourth working station (54) at a preset speed (V), and then rewinding the photovoltaic module (30) to form a photovoltaic module roll (40); and
a temperature and pressure control step, including performing temperature and pressure control processing on the photovoltaic module roll (40).

2. The packaging method for a photovoltaic module according to claim 1, wherein the conductive film (21) is a conductive copper film, the first packaging adhesive film (22) and the second packaging adhesive film (24) are thermoplastic olefin (TPO) adhesive films, and the polymer substrate (23) is made of polyethylene terephthalate (PET) or polyethylene naphthalate (PEN) or polyimide (PI) or a combination thereof, and the first intermediate film (25) and the second intermediate film (26) are polyvinyl butyral (PVB) adhesive films.

3. The packaging method for a photovoltaic module according to claim 1, wherein the packaging step comprises:
transporting the flexible substrate (2) to pass through the first working station (51) so as to adhering a top surface of the flexible substrate (2) to the second packing adhesive film (24);
transporting the flexible substrate (2) to pass through the second working station (52) at a first preset speed (V1) so as to adhere two relative surfaces of the flexible substrate (2) to the first intermediate film (25) and the second intermediate film (26) respectively and synchronously;
transporting the flexible substrate (2) to pass through the third working station (53) at a second preset speed (V2) so as to adhere a top surface of the first intermediate film (25) of the flexible substrate (2) to the water resistant film (27); and
transporting the flexible substrate (2) to pass through the fourth working station (54) at a third preset speed (V3) so as to adhere a bottom surface of the flexible substrate (2) to the back-sheet (28) to obtain the photovoltaic module (30).

4. The packaging method for a photovoltaic module according to claim 3, wherein the first preset speed (V1), the second preset speed (V2) and the third preset speed (V3) are all between 0.2 m/min and 5 m/min.

5. The packaging method for a photovoltaic module according to claim 3, wherein the back-sheet (28) is a single-sided fluorine-containing or a double-sided fluorine-containing back-sheet.

6. The packaging method for a photovoltaic module according to claim 3, further comprising:
transporting the photovoltaic module (30) to a preheating chamber (71) of a roll laminating machine (70) at a fourth preset speed (V4) for performing preheating in three preheating phases, wherein the three preheating phases comprises:
a first preheating phase of preheating in a temperature range of 50 °C to 70 °C;
a second preheating phase of preheating in a temperature range of 90 °C to 110 °C; and
a third preheating phase of preheating in a temperature range of 130 °C to 150 °C.

7. The packaging method for a photovoltaic module according to claim 6, wherein the fourth preset speed (V4) is between 0.5 m/min and 3 m/min.

8. The packaging method for a photovoltaic module according to claim 6, further comprising heating and pressurizing the photovoltaic module (30) after transporting the photovoltaic module (30) to the preheating chamber (71) of the roll laminating machine (70) at the fourth preset speed (V4).

9. The packaging method for a photovoltaic module according to claim 8, further comprising cooling the photovoltaic module (30) after heating and pressurizing the photovoltaic module (30) and rewinding the photovoltaic module (30) to form the photovoltaic module roll (40) when the temperature of the photovoltaic module (30) is equal to or less than 40 °C.

10. The packaging method for a photovoltaic module according to claim 9, wherein a separating plate (411) is placed between adjacent sheets of the photovoltaic module roll (40) while rewinding the photovoltaic module (30).

11. The packaging method for a photovoltaic module according to claim 10, wherein the separating plate (411) is a silicone plate.

12. The packaging method for a photovoltaic module according to claim 1, wherein the temperature and pressure control step comprises:
transporting the photovoltaic module roll (40) to a pressure forming equipment (60), and adjusting temperature and pressure in the pressure forming equipment so as to laminate the photovoltaic module roll (40).

13. The packaging method for a photovoltaic module according to claim 12, wherein adjusting temperature and pressure in the pressure forming equipment (60) comprises:
increasing temperature and pressure for the photovoltaic module roll (40) in a first preset time period and a first preset temperature range;
maintaining the temperature and the pressure for the photovoltaic module roll (40) in a second preset time period;
decreasing the temperature and maintaining the pressure for the photovoltaic module roll (40) in a third preset time period; and
decreasing the temperature and the pressure for the photovoltaic module roll (40).

14. The packaging method for a photovoltaic module according to claim 13, wherein an upper limit of the pressure is kept to 10 bar to 12 bar in the phase of increasing the temperature and the pressure, the lower limit of the temperature is kept to 50 °C in the phase of decreasing the temperature and maintaining the pressure, and the pressure is decreased to a standard atmospheric pressure and the temperature for the photovoltaic module roll (40) is decreased to room temperature in the phase of decreasing the temperature and the pressure.

15. The packaging method for a photovoltaic module according to claim 13, wherein the first preset time period is between 30 minutes and 50 minutes, the first preset temperature is between 130 °C and 140 °C the second preset time period is between 50 minutes and 70 minutes, and the third preset time period is between 120 minutes and 150 minutes.
